# EUROPEAN PATENT APPLICATION

(11) **EP 3 506 368 A1**
(43) Date of publication of application: **03.07.2019**
(21) Application number: 18213792.7
(22) Date of filing: 19.12.2018
(51) Int. Cl.: H01L 29/786

(54) **THIN FILM TRANSISTOR SUBSTRATE, LIQUID CRYSTAL DISPLAY DEVICE INCLUDING SAME, AND METHOD FOR PRODUCING THIN FILM TRANSISTOR SUBSTRATE**

(30) Priority: 26.12.2017 JP 2017249571
(71) Applicant: Sharp Kabushiki Kaisha, Sakai-shi Osaka 590-8522 (JP)
(72) Inventor: MISAKI, Katsunori, Yonago-shi, Tottori 689-3524 (JP)
(74) Representative: Müller-Boré & Partner Patentanwälte PartG mbB

(57) **Abstract**

The present invention provides a thin film transistor substrate capable of stabilizing TFT characteristics, a liquid crystal display device including the thin film transistor substrate, and a method for producing a thin film transistor substrate. The thin film transistor substrate of the present invention is a thin film transistor substrate including a bottom gate thin film transistor. The thin film transistor includes a semiconductor layer which includes an In-Ga-Zn-0 first oxide semiconductor layer and an In-Ga-Zn-0 second oxide semiconductor layer covering the first oxide semiconductor layer. In the first oxide semiconductor layer, indium has a higher proportion than gallium and than zinc. In the second oxide semiconductor layer, gallium has a higher proportion than indium and than zinc.

## Description

### TECHNICAL FIELD

The present invention relates to a thin film transistor (hereinafter also referred to as TFT) substrate, a liquid crystal display device including the TFT substrate, and a method for producing a TFT substrate. In particular, the present invention relates to a TFT substrate including a TFT that includes a semiconductor layer containing an oxide semiconductor, a liquid crystal display device, and a method for producing a TFT substrate.

### BACKGROUND ART

A TFT substrate constituting a liquid crystal display device includes TFTs as switching elements of pixels, the smallest units of an image. In recent years, a TFT that includes a semiconductor layer containing an oxide semiconductor (hereinafter also referred to as an oxide semiconductor layer) has been proposed as an alternative to conventional TFTs that include a semiconductor layer containing amorphous silicon. The proposed TFT has favorable characteristics, including high mobility, high reliability, and low off-state current.

A typical bottom gate TFT includes, for example, a gate electrode disposed on a glass substrate, a gate insulating film covering the gate electrode, a semiconductor layer disposed on the gate insulating film and overlapping the gate electrode, and a source electrode and drain electrode disposed with a space therebetween on the gate insulating film and overlapping the semiconductor layer. The TFT includes a channel region in an exposed portion of the semiconductor layer between the source electrode and the drain electrode.

For example, Patent Literature 1 discloses a bottom gate TFT including the oxide semiconductor layer, wherein the oxide semiconductor layer is a stack of a first oxide semiconductor layer containing In, Ga, Zn, Sn, and O and a second oxide semiconductor layer containing In, Ga, Zn, and O.

### CITATION LIST

### - Patent Literature

Patent Literature 1: JP 2014-13892 A

### SUMMARY OF INVENTION

### - Technical problem

The oxide semiconductor layer is easily dissolved in acid etchants commonly used in wet etching of the source electrode and the drain electrode. In a channel etch type TFT including the oxide semiconductor layer, thus, the source electrode and the drain electrode are patterned by dry etching.

However, when the oxide semiconductor layer has a layered structure including two or more layers and the source electrode and the drain electrode are dry etched after patterning the oxide semiconductor layer, TFT characteristics may be depressed. Specifically, the threshold value may greatly shift to the negative side, or the oxide semiconductor layer may become conductive and thereby cause leakage current between the source electrode and the drain electrode. The same troubles can occur also when a protective film (e.g., a protective insulating film in a channel etch type TFT, an etching stopper layer (channel protective film) in an etch stopper type TFT) is formed with a chemical vapor deposition (CVD) device, particularly a plasma CVD device, after patterning the oxide semiconductor layer.

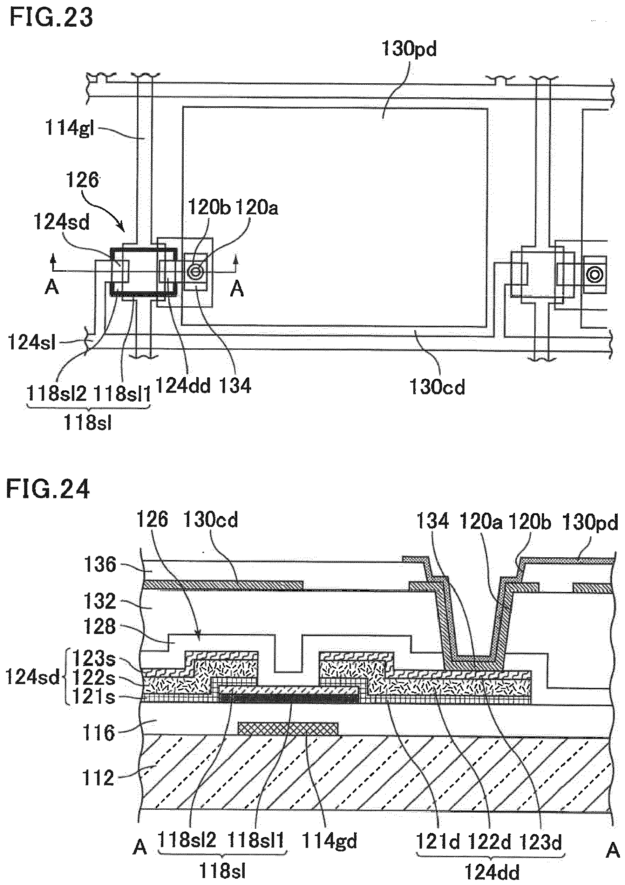

This issue is more specifically described below with reference to Fig. 23 to Fig. 26. As shown in Fig. 23 and Fig. 24, a TFT substrate according to Comparative Embodiment 1 includes an insulating substrate 112 as a base substrate and, on the insulating substrate 112, a plurality of gate lines 114gl extending in parallel with each other and a plurality of source lines 124sl extending in parallel with each other in a direction in which they cross the gate lines 114gl via a gate insulating film 116. The TFT substrate according to Comparative Embodiment 1 further includes: a channel etch type TFT 126 including a gate electrode 114gd disposed on the insulating substrate 112, an oxide semiconductor layer 118sl disposed on the gate insulating film 116 and overlapping the gate electrode 114gd, and a source electrode 124sd and a drain electrode 124dd facing each other on the oxide semiconductor layer 118sl, part of each of the source electrode 124sd and the drain electrode 124dd connected to the oxide semiconductor layer 118sl; protective insulating films 128 and 132 covering the TFT 126; a common electrode 130cd and a connection electrode 134 disposed on the protective insulating film 132; a protective insulating film 136 covering the common electrode 130cd and the connection electrode 134; and a pixel electrode 130pd disposed on the protective insulating film 136. The source electrode 124sd and the drain electrode 124dd each include a stack in which a first conductive layer 121s or 121d, a second conductive layer 122s or 122d, and a third conductive layer 123s or 123d are stacked in sequence. The source electrode 124sd is connected to a branch point of the corresponding source line 124sl. The gate electrode 114gd is a part of the gate line 114gl constituting the corresponding intersection. The protective insulating films 128 and 132 have, at the portions corresponding to the drain electrode 124dd, a contact hole 120a that reaches the drain electrode 124dd. The protective insulating film 136 has a contact hole 120b at the portion corresponding to the drain electrode 124dd. The pixel electrode 130pd is connected to the drain electrode 124dd through the contact holes 120a and 120b and via the connection electrode 134.

The oxide semiconductor layer 118sl includes a stack in which a first semiconductor layer containing a first oxide semiconductor (hereinafter also referred to as a first oxide semiconductor layer) 118sl1 and a second semiconductor layer containing a second oxide semiconductor (hereinafter also referred to as a second oxide semiconductor layer) 118sl2 are stacked in sequence. The oxide semiconductor layer 118sl may be formed by, for example, first forming a first semiconductor film containing a first oxide semiconductor in which indium has a higher proportion than gallium and than zinc, subsequently forming a second semiconductor film containing a second oxide semiconductor in which gallium has a higher proportion than indium and than zinc, and then patterning the stacked films all at once into the same pattern (island shape).

In Comparative Embodiment 1, the source electrode 124sd and the drain electrode 124dd are formed by dry etching as mentioned above. During dry etching, plasma of chlorine-containing gas may reduce the edges of the first oxide semiconductor layer 118sl1 (lower layer) exposed from the second oxide semiconductor layer 118sl2 (upper layer), particularly the edge portions (shown in bold lines in Fig. 23) exposed from the source electrode 124sd and the drain electrode 124dd. This may cause depression of TFT characteristics. Furthermore, during formation of, for example, the protective insulating film 128 with a CVD device, particularly a plasma CVD device, hydrogen plasma may reduce the edges of the first oxide semiconductor layer 118sl1 (lower layer) exposed from the second oxide semiconductor layer 118sl2 (upper layer), particularly the edge portions (shown in bold lines in Fig. 23) exposed from the source electrode 124sd and the drain electrode 124dd. This may similarly cause depression of TFT characteristics.

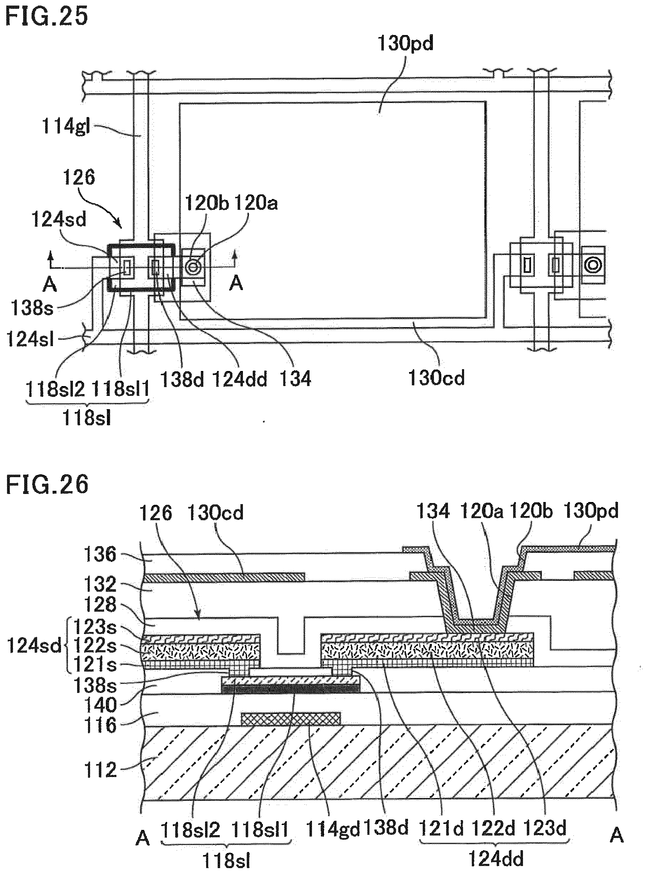

As shown in Fig. 25 and Fig. 26, a TFT substrate according to Comparative Embodiment 2 is substantially the same as that according to Comparative Embodiment 1 except that the TFT 126 is an etch stopper type TFT.

As shown in Fig. 25, the TFT substrate according to Comparative Embodiment 2 has the same plan layout as the TFT substrate according to Comparative Embodiment 1 except that an etching stopper layer 140 shown in Fig. 26 has contact holes 138s and 138d overlapping the source electrode 124sd and the drain electrode 124dd.

As shown in Fig. 26, the TFT substrate according to Comparative Embodiment 2 includes the etching stopper layer 140 covering the oxide semiconductor layer 118sl and the gate insulating film 116 except for the portions where the contact holes 138s and 138d are formed.

In Comparative Embodiment 2, during formation of the etching stopper layer 140 with a CVD device, particularly a plasma CVD device, hydrogen plasma may reduce the entire edges of the first oxide semiconductor layer 118sl1 (lower layer) exposed from the second oxide semiconductor layer 118sl2 (upper layer). This may cause depression of TFT characteristics as in Comparative Example 1. Also during the subsequent dry etching of the source electrode 124sd and the drain electrode 124dd, or during formation of, for example, the protective insulating film 128 with a CVD device, particularly a plasma CVD device, plasma of chlorine-containing gas or hydrogen plasma may reduce the edges of the first oxide semiconductor layer 118sl1 (lower layer) not covered with the second oxide semiconductor layer 118sl2 (upper layer), particularly the edge portions (shown in bold lines in Fig. 25) not covered with the source electrode 124sd and the drain electrode 124dd. Although the etching stopper layer 140 can moderate the reducing reaction, the edges of the first oxide semiconductor layer 118sl1 can be reduced even with the presence of the etching stopper layer 140 as the plasma of chlorine-containing gas or hydrogen plasm may damage the etching stopper layer 140 to pass therethrough.

Although Comparative Embodiments 1 and 2 describe the oxide semiconductor layer 118sl including two layers, the oxide semiconductor layers 118sl1 and 118sl2, the same issue can occur with an oxide semiconductor layer 118sl including three or more oxide semiconductor layers.

The TFT disclosed in Patent Literature 1 may similarly suffer depression of TFT characteristics because the edges of the lower oxide semiconductor layer in the TFT are not covered with the upper oxide semiconductor layer.

The present invention was made in view of the situation and aims to provide a thin film transistor substrate capable of stabilizing TFT characteristics, a liquid crystal display device including the thin film transistor substrate, and a method for producing a thin film transistor substrate.

### - Solution to problem

One aspect of the present invention may be a thin film transistor substrate including: a base substrate; and a thin film transistor including a gate electrode disposed on the base substrate, a gate insulating film covering the gate electrode, a semiconductor layer disposed on the gate insulating film and overlapping the gate electrode, and a source electrode and a drain electrode facing each other on the semiconductor layer, part of each of the source electrode and the drain electrode connected to the semiconductor layer, wherein the semiconductor layer includes a first semiconductor layer containing a first oxide semiconductor and a second semiconductor layer containing a second oxide semiconductor, with the second semiconductor layer covering the first semiconductor layer.

Another aspect of the present invention may be a liquid crystal display device including: the thin film transistor of the above aspect of the present invention; a counter substrate facing the thin film transistor substrate; and a liquid crystal layer disposed between the thin film transistor substrate and the counter substrate.

Still another aspect of the present invention may be a method for producing a thin film transistor substrate including: a first patterning step of forming a conductive film on a base substrate and patterning the conductive film with a first photomask to form a gate electrode, a gate insulating film forming step of forming a gate insulating film to cover the gate electrode; a second patterning step of forming a first semiconductor film containing a first oxide semiconductor on the gate insulating film and patterning the first semiconductor film with a second photomask to form a first semiconductor layer; a third patterning step of forming a second semiconductor film containing a second oxide semiconductor to cover the first semiconductor layer and patterning the second semiconductor film with a third photomask to form a second semiconductor layer to cover the first semiconductor layer; and a fourth patterning step of forming a conductive film to cover the first semiconductor layer and the second semiconductor layer and patterning the conductive film by dry etching with a fourth photomask to form a source electrode and a drain electrode.

### - Advantageous Effects of Invention

The present invention can provide a thin film transistor substrate capable of stabilizing TFT characteristics and a method for producing a thin film transistor substrate. Use of this thin film transistor substrate in a liquid crystal display device can increase the yield.

### BRIEF DESCRIPTION OF DRAWINGS

Fig. 1 is a schematic plan view illustrating a liquid crystal display device according to Embodiment 1.
Fig. 2 is a cross-sectional view illustrating a cross-sectional structure along the II-II line in Fig. 1.
Fig. 3 is a schematic plan view illustrating the structures of one pixel and the terminal of each line in a TFT substrate according to Embodiment 1.
Fig. 4 includes cross-sectional views illustrating cross-sectional structures along the A-A line and the B-B line in Fig. 3.
Fig. 5 includes cross-sectional views illustrating portions corresponding to the portions illustrated in Fig. 4, wherein a gate electrode has been formed by a first patterning step in production of the TFT substrate according to Embodiment 1.
Fig. 6 includes cross-sectional views illustrating portions corresponding to the portions illustrated in Fig. 4, wherein a gate insulating film has been formed by a gate insulating film forming step in production of the TFT substrate according to Embodiment 1.
Fig. 7 includes cross-sectional views illustrating portions corresponding to the portions illustrated in Fig. 4, wherein a first oxide semiconductor layer has been formed by a second patterning step in production of the TFT substrate according to Embodiment 1.
Fig. 8 includes cross-sectional views illustrating portions corresponding to the portions illustrated in Fig. 4, wherein a second oxide semiconductor layer has been formed by a third patterning step in production of the TFT substrate according to Embodiment 1.
Fig. 9 includes cross-sectional views illustrating portions corresponding to the portions illustrated in Fig. 4, wherein a molybdenum film, an aluminum film, and a molybdenum film have been patterned by a fourth patterning step in production of the TFT substrate according to Embodiment 1.
Fig. 10 includes cross-sectional views illustrating portions corresponding to the portions illustrated in Fig. 4, wherein a protective insulating film containing silicon nitride has been formed by a fifth patterning step in production of the TFT substrate according to Embodiment 1.
Fig. 11 includes cross-sectional views illustrating portions corresponding to the portions illustrated in Fig. 4, wherein a protective insulating film containing a transparent insulating resin has been formed by the fifth patterning step in after production of the TFT substrate according to Embodiment 1
Fig. 12 includes cross-sectional views illustrating portions corresponding to the portions illustrated in Fig. 4, wherein contact holes have been formed in the gate insulating film and the protective insulating film containing silicon nitride by the fifth patterning step in production of the TFT substrate according to Embodiment 1.
Fig. 13 includes cross-sectional views illustrating portions corresponding to the portions illustrated in Fig. 4, wherein a common electrode has been formed by a sixth patterning step in production of the TFT substrate according to Embodiment 1.
Fig. 14 includes cross-sectional views illustrating portions corresponding to the portions illustrated in Fig. 4, wherein a protective insulating film including a silicon oxide film or a silicon nitride film has been formed by a seventh patterning step in production of the TFT substrate according to Embodiment 1.
Fig. 15 is a schematic plan view illustrating the structures of one pixel and the terminal of each line in a TFT substrate according to Embodiment 2.
Fig. 16 includes cross-sectional views illustrating cross-sectional structures along the A-A line and the B-B line in Fig. 15.
Fig. 17 includes cross-sectional views illustrating portions corresponding to the portions illustrated in Fig. 16, wherein an etching stopper layer has been formed by a fourth patterning step in production of the TFT substrate according to Embodiment 2.
Fig. 18 includes cross-sectional views illustrating portions corresponding to the portions illustrated in Fig. 16, wherein contact holes have been formed in the etching stopper layer by the fourth patterning step in production of the TFT substrate according to Embodiment 2.
Fig. 19 is a schematic plan view illustrating the structures of one pixel and the terminal of each line in a TFT substrate according to Embodiment 3.
Fig. 20 includes cross-sectional views illustrating cross-sectional structures along the A-A line and the B-B line in Fig. 19.
Fig. 21 is a schematic plan view illustrating the structures of one pixel and the terminal of each line in a TFT substrate according to Embodiment 4.
Fig. 22 includes cross-sectional views illustrating cross-sectional structures along the A-A line and the B-B line in Fig. 21.
Fig. 23 is a schematic plan view illustrating the structure of one pixel of a TFT substrate according to Comparative Embodiment 1.
Fig. 24 includes cross-sectional views illustrating cross-sectional structures along the A-A line and the B-B line in Fig. 23.
Fig. 25 is a schematic plan view illustrating the structure of one pixel of a TFT substrate according to Comparative Embodiment. 2.
Fig. 26 is a cross-sectional view illustrating a cross-sectional structure along the A-A line in Fig. 25.

### DESCRIPTION OF EMBODIMENTS

Hereinafter, embodiments of the present invention are described. The present invention is not limited to the descriptions of the following embodiments, and design changes can be appropriately made within the scope of the present invention.

The proportion of each metal element constituting an oxide semiconductor herein means the proportion (atom%) of the metal element relative to all the metal elements, excluding oxygen, contained in the oxide semiconductor.

### <<Embodiment 1>>

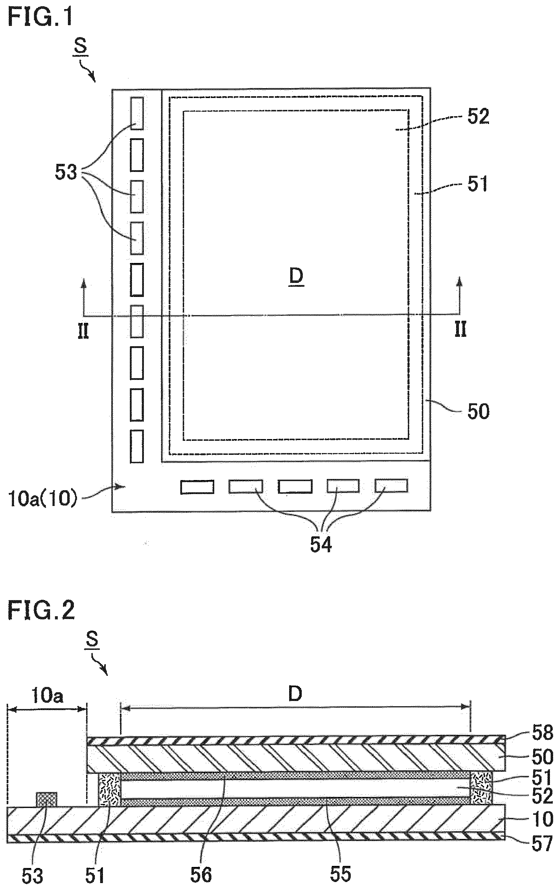

Fig. 1 is a schematic plan view of a liquid crystal display device S according to the present embodiment. Fig. 2 is a cross-sectional view illustrating a cross-sectional structure along the II-II line in Fig. 1. In Fig. 1, a polarizing plate 58 shown in Fig. 2 is omitted.

### <Structure of liquid crystal display device S>

The liquid crystal display device S includes a TFT substrate 10 and a counter substrate 50 facing each other, a frame-shaped seal 51 bonding the peripheries of the TFT substrate 10 and the counter substrate 50, and a liquid crystal layer 52 sealed inside the seal 51 between the TFT substrate 10 and the counter substrate 50.

The liquid crystal display device S is a transmissive liquid crystal display device. The liquid crystal display device S has a display area D for image display in the region where the TFT substrate 10 and the counter substrate 50 overlap inside the seal 51, that is, the region where the liquid crystal layer 52 is formed. Outside the display area D is provided a terminal region 10a that is a portion of the TFT substrate 10 protruding in, for example, an L shape from the counter substrate 50.

For example, the display area D may be a rectangular region. The display area D includes pixels, the smallest units of an image, arranged in a matrix pattern. The terminal region 10a has a plurality of gate driver integrated circuit (hereinafter referred to as IC) chips 53 mounted on one side (left side in Fig. 1) via anisotropic conductive films (hereinafter referred to as ACFs). The terminal region 10a also has a plurality of source driver IC chips 54 mounted on another side (lower side in Fig. 1) via ACFs.

The TFT substrate 10 and the counter substrate 50 are rectangular, for example. As shown in Fig. 2, the TFT substrate 10 and the counter substrate 50 have alignment films 55 and 56, respectively, on their inner surfaces facing each other and have polarizing plates 57 and 58, respectively, on their outer surfaces. The liquid crystal layer 52 includes a nematic liquid crystal material having electrooptic characteristics.

### <Structure of TFT substrate 10>

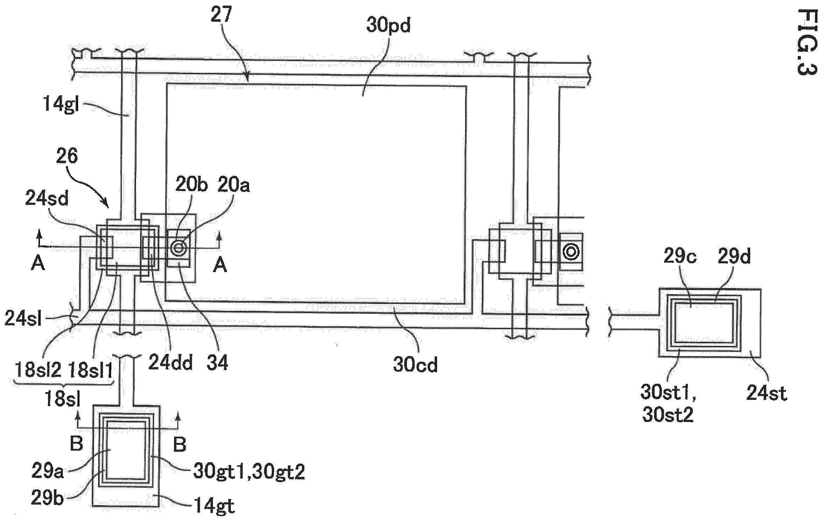

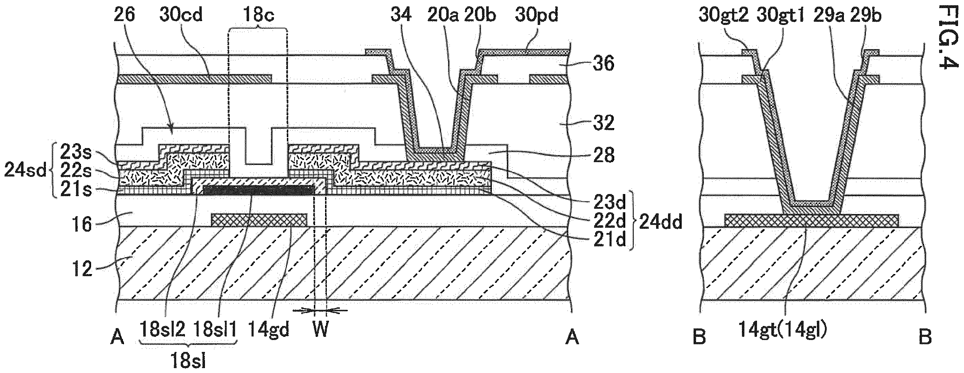

Fig. 3 and Fig. 4 are schematic views each illustrating the TFT substrate 10. Fig. 3 is a schematic plan view illustrating one pixel and the terminal of each line. Fig. 4 includes cross-sectional views illustrating, from left to right in the figure, cross-sectional structures along the A-A line and the B-B line in Fig. 3.

The TFT substrate 10 includes an insulating substrate 12 such as a glass substrate that is a base substrate shown in Fig. 4. In the display area D, as shown in Fig. 3, the TFT substrate includes, on the insulating substrate 12, a plurality of gate lines 14gl extending in parallel with each other and a plurality of source lines 24sl extending in parallel with each other in a direction in which they cross the gate lines 14gl via an insulating film. The gate lines 14gl and source lines 24sl as a whole are formed in a grid pattern to define the pixels.

The TFT substrate 10 further includes a TFT 26, a storage capacitor 27, and a pixel electrode 30pd at each intersection of the gate lines 14gl and the source lines 24sl, in other words, in each pixel. The TFT substrate 10 further includes a common electrode 30cd common to all the pixels.

Each TFT 26 is a channel etch type TFT. As shown in Fig. 4 (A-A cross section), the TFT 26 includes: a gate electrode 14gd disposed on the insulating substrate 12; a gate insulating film 16 covering the gate electrode 14gd; a semiconductor layer 18sl containing an oxide semiconductor (oxide semiconductor layer), which is disposed on the gate insulating film 16 and overlaps the gate electrode 14gd; and a source electrode 24sd and a drain electrode 24dd disposed on the gate insulating film 16, where the source electrode 24sd and the drain electrode 24dd face each other on the oxide semiconductor layer 18sl and part of each of the source electrode 24sd and the drain electrode 24dd is connected to the oxide semiconductor layer 18sl. The TFT 26 includes a channel region 18c in a portion of the semiconductor layer 18sl between the source electrode 24sd and the drain electrode 24dd. The source electrode 24sd is connected to a branch point of the corresponding source line 24sl.

The gate electrode 14gd is a part of the gate line 14gl constituting the corresponding intersection. As shown in Fig. 3, the gate electrode 14gd has a protruding portion protruding toward both sides in the width direction of the gate line 14gl. The width of the protruding portion determines the channel length of the TFT 26. In the channel length direction of the TFT 26, the width of the gate electrode 14gd is smaller than the width of the oxide semiconductor layer 18sl, but the gate electrode 14gd at least overlaps the channel region 18c between the source electrode 24sd and the drain electrode 24dd. Although not shown, the gate electrode 14gd, as well as the gate line 14gl, includes an aluminum (Al) layer and a molybdenum (Mo) layer integrally stacked in sequence.

The gate insulating film 16 includes, for example, silicon nitride (SiN), silicon oxide (SiO₂), or a layered film in which a silicon nitride film and a silicon oxide film are integrally stacked in sequence.

The oxide semiconductor layer 18sl includes a first semiconductor layer containing a first oxide semiconductor (first oxide semiconductor layer) 18sl1 and a second semiconductor layer containing a second oxide semiconductor (second oxide semiconductor layer) 18sl2, with the second semiconductor layer 18sl2 covering the first oxide semiconductor layer 18sl1. The second oxide semiconductor layer 18sl2 overlaps the entire first oxide semiconductor layer 18sl1, covering the entire top surface and the entire side surfaces of the first oxide semiconductor layer 18sl1. That is, the first oxide semiconductor layer 18sl1 is completely covered with the second oxide semiconductor layer 18sl2. Since the first oxide semiconductor layer 18sl1 (lower layer) is covered with the second oxide semiconductor layer 18sl2 (upper layer), each TFT 26 can achieve high mobility owing to the first oxide semiconductor layer 18sl1 (lower layer) and a stable threshold value owing to the second oxide semiconductor layer 18sl2 (upper layer). Moreover, it is possible to prevent the threshold value of each TFT 26 from shifting to the negative side and prevent the oxide semiconductor layer 18sl from becoming conductive in the steps (plasma treatment) after the patterning of the oxide semiconductor layer 18sl. As a result, each TFT 26 can have stable TFT characteristics.

For the second oxide semiconductor layer 18sl2, the width W of the portion protruding from the first oxide semiconductor layer 18sl1 is not limited, and may be appropriately set. The width W is preferably 0.5 µm or greater, more preferably 2 µm or greater. The upper limit of the width W is also not limited. For example, it may be 10 µm or smaller.

The oxide semiconductor layer 18sl contains an indium gallium zinc oxide (hereinafter referred to as In-Ga-Zn-O) oxide semiconductor. The first oxide semiconductor of the first oxide semiconductor layer 18sl1 and the second oxide semiconductor of the second oxide semiconductor layer 18sl2 also each contain indium, gallium, zinc, and oxygen. The specific proportion of each component of the first oxide semiconductor and the second oxide semiconductor is not limited and may be appropriately set. Preferably, in the first oxide semiconductor, indium has a higher proportion than gallium and than zinc, and in the second oxide semiconductor, gallium has a higher proportion than indium and than zinc. With a relatively high proportion of indium, each TFT 26 can effectively achieve high mobility as the TFT characteristics. If the TFT includes only an oxide semiconductor layer containing an oxide semiconductor with a high proportion of indium, the process (e.g., dry etching, film formation by a CVD method) after the formation of the oxide semiconductor layer may cause the deletion of TFT characteristics (great shift of the threshold value to the negative side or change of the oxide semiconductor layer 18sl into a conductive layer). If the TFT includes only an oxide semiconductor layer containing an oxide semiconductor with a relatively high proportion of gallium, the deletion of TFT characteristics by the process (e.g., dry etching, film formation by a CVD method) after the formation of the oxide semiconductor layer can be effectively reduced, but high mobility may be difficult to achieve.

As described later, the first oxide semiconductor layer 18sl1 is formed by forming, as a solid film, a first semiconductor film containing the first oxide semiconductor on the entire substrate surface and then patterning the first semiconductor film by wet etching. The second oxide semiconductor layer 18s12 is formed by forming, as a solid film, a second semiconductor film containing the second oxide semiconductor on the entire substrate surface after patterning the first semiconductor film, and then patterning the second semiconductor film by wet etching.

The source electrode 24sd and the drain electrode 24dd each include a stack in a which molybdenum (Mo) layer 21s or 21d as a first conductive layer, an aluminum (Al) layer 22s or 22d as a second conductive layer, and a molybdenum (Mo) layer 23s or 23d as a third conductive layer are integrally stacked in sequence.

As described later, the molybdenum layers 21s and 21d, the aluminum layers 22s and 22d, and the molybdenum layers 23s and 23d are formed by forming, as a solid film, a layered film including a molybdenum film, an aluminum film, and molybdenum film on the entire substrate surface and then patterning the layered film by dry etching.

As shown in Fig. 4, each TFT 26 is covered with a protective insulating film 28 containing, for example, silicon nitride (SiN) and a protective insulating film 32 containing a transparent insulating resin. The common electrode 30cd and a connection electrode 34 are disposed on the protective insulating film 32. The common electrode 30cd and the connection electrode 34 are covered with a protective insulating film 36 containing silicon nitride (SiN) or silicon oxide (SiO₂). The pixel electrode 30pd is disposed on the protective insulating film 36.

The common electrode 30cd, each connection electrode 34, and each pixel electrode 30pd contain indium tin oxide (hereinafter referred to as ITO) or indium zinc oxide (hereinafter referred to as IZO). The common electrode 30cd is disposed on substantially the entire display area D. Each pixel electrode 30pd is disposed on substantially the entire corresponding pixel. Here, each pixel electrode 30pd has a plurality of slits (not shown). The protective insulating films 28 and 32 have, at the portions corresponding to the drain electrode 24dd of each pixel, a contact hole 20a that reaches the drain electrode 24dd. The protective insulating film 36 has a contact hole 20b at the portion corresponding to the drain electrode 24dd of each pixel. Each connection electrode 34 is formed in an island shape that overlaps the contact hole 20a of the corresponding pixel. Each pixel electrode 30pd is connected to the drain electrode 24dd of the corresponding pixel through the contact holes 20a and 20b via the connection electrode 34.

Each storage capacitor 27 includes the corresponding pixel electrode 30pd, a dielectric layer formed of a portion of the protective insulating film corresponding to the pixel electrode 30pd, and a portion of the common electrode corresponding to the pixel electrode 30pd via the dielectric layer.

Each gate line 14gl is extended to the terminal region 10a on which the gate driver IC chips 53 are mounted. The end of the extended line forms a gate terminal 14gt shown in Fig. 3. The gate terminal 14gt is connected to a gate connection electrode 30gt1 disposed on the protective insulating film 32 and a gate connection electrode 30gt2 disposed on the protective insulating film 36, via the contact hole 29a provided in the gate insulating film 16 and the protective insulating films 28 and 32 shown in Fig. 4 (B-B cross section) and the contact hole 29b provided in the protective insulating film 36 shown in Fig. 4 (B-B cross section). The gate connection electrodes 30gt1 and 30gt2 constitute an electrode for electrical connection with the gate driver IC chip 53.

Each source line 24sl is extended to the terminal region 10a on which the source driver IC chips 54 are mounted. The end of the extended line forms a source terminal 24st shown in Fig. 3. The source terminal 24st is connected to a source connection electrode 30st1 disposed on the protective insulating film 32 and a source connection electrode 30st2 disposed on the protective insulating film 36, via the contact hole 29c provided in the protective insulating films 28 and 32 and the contact hole 29d provided in the protective insulating film 36. The source connection electrodes 30st1 and 30st2 constitute an electrode for electrical connection with the source driver IC chip 54.

The edges of the common electrode 30cd extend to the region where the seal 51 is disposed. The edges are connected to a common line (not shown). To the common electrode 30cd, common voltage is applied via the common line.

### <Structure of counter substrate 50>

Although not shown in the drawings, the counter substrate 50 includes, on the insulating substrate serving as the base substrate, a black matrix in a grid pattern corresponding to the gate lines 14gl and the source lines 24sl, color filters of multiple colors including a red layer, a green layer, and a blue layer arranged periodically in the cells of the grid of black matrix, an overcoat layer containing a transparent insulating resin and covering the black matrix and the color filters, and pillar-shaped photo spacers disposed on the overcoat layer.

### <Operation of liquid crystal display device S>

In each pixel of the liquid crystal display device S having the above structure, when the TFT 26 is turned on in response to a gate signal sent from the gate driver IC chip 53 to the gate electrode 14 gd through the gate line 14gl, a source signal is sent from the source driver IC chip 54 to the source electrode 24sd through the source line 24sl, so that a predetermined amount of charge is written to the pixel electrode 3.0pd through the oxide semiconductor layer 18sl and the drain electrode 24dd, and simultaneously the storage capacitor 27 is charged. At this time, a potential difference is generated between the pixel electrode 30pd and the common electrode 30cd, whereby a predetermined voltage is applied to the liquid crystal layer 52. When the TFT 26 is off, storage capacitance formed in the storage capacitor 27 suppresses a decrease in voltage written to the corresponding pixel electrode 30pd. In the liquid crystal display device S, the alignment of liquid crystal molecules is changed in each pixel according to the magnitude of the voltage applied to the liquid crystal layer 52, whereby the light transmittance of the liquid crystal layer 52 is adjusted and an image is displayed.

### -Production method-

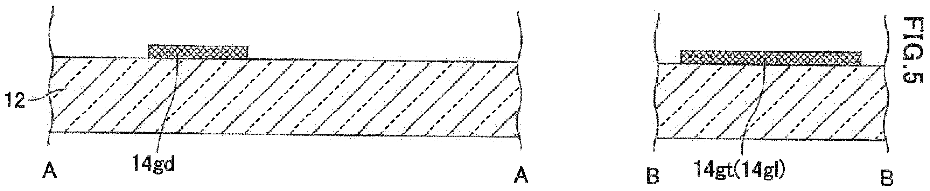

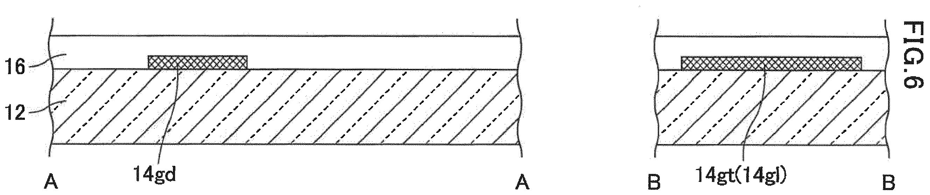

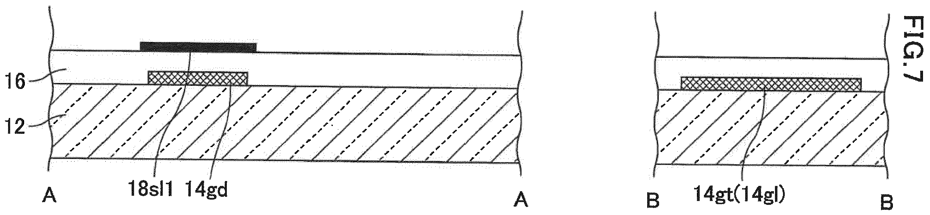

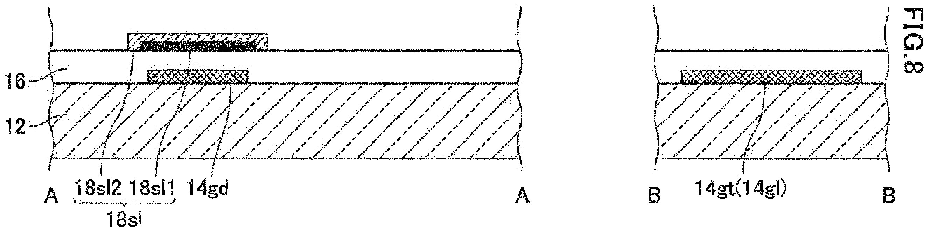

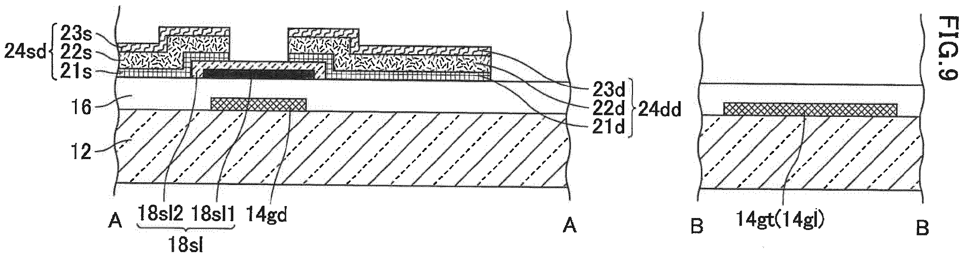

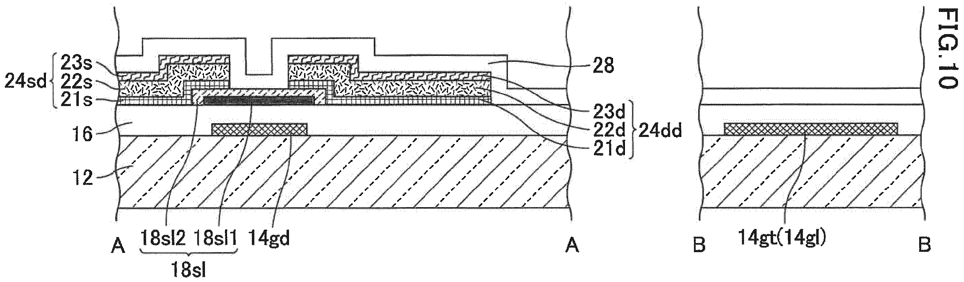

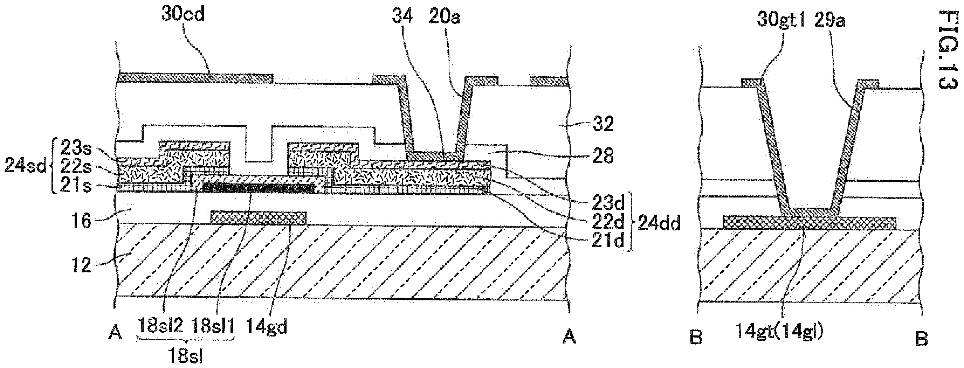

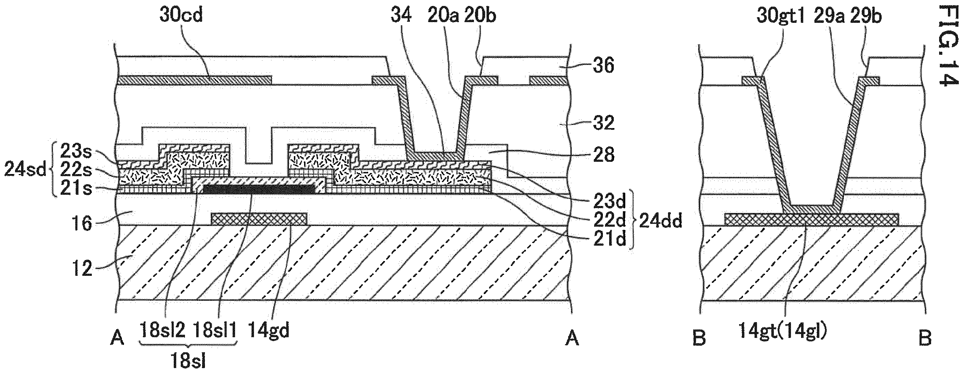

Next, with reference to Fig. 5 to Fig. 16, exemplary methods for producing the TFT substrate 10 and the liquid crystal display device S are described. Fig. 5 to Fig. 14 each include cross-sectional views of portions corresponding to the portions illustrated in Fig. 4. Fig. 5 illustrates a first patterning step in the method for producing the TFT substrate 10. Fig. 6 illustrates a gate insulating film forming step in the method for producing the TFT substrate 10. Fig. 7 illustrates a second patterning step in the method for producing the TFT substrate 10. Fig. 8 illustrates a third patterning step in the method for producing the TFT substrate 10. Fig. 9 illustrates a fourth patterning step in the method for producing the TFT substrate 10. Fig. 10 to Fig. 12 illustrate a fifth patterning step in the method for producing the TFT substrate 10. Fig. 13 illustrates a sixth patterning step in the method for producing the TFT substrate 10. Fig. 14 illustrates a seventh patterning step in the method for producing the TFT substrate 10.

The method for producing the liquid crystal display device S of the present embodiment includes a TFT substrate producing step, a counter substrate producing step, an attaching step, and a mounting step.

### <TFT substrate producing step>

The TFT substrate producing step includes first to eighth patterning steps.

### <First patterning step>

The insulating substrate 12 such as a glass substrate is provided in advance. On the insulating substrate 12 are formed, for example, an aluminum film (e.g., having a thickness of about 200 nm) and a molybdenum film (e.g., having a thickness of about 100 nm) in sequence by a sputtering method, whereby a layered conductive film is formed. Instead of the molybdenum film, a molybdenum niobium film (e.g., having a thickness of about 100 nm) may be formed. Subsequently, a resist pattern is formed on the layered conductive film by photolithography with a first photomask. The resist pattern is formed on the portions where the gate lines 14gl, the gate electrodes 14gd, and the gate terminals 14gt are to be formed. Then, using this resist pattern as a mask, the layered conductive film is patterned by reactive ion etching (hereinafter refered to as RIE), a type of dry etching, using chlorine-containing gas. Thereafter, the resist pattern is stripped with a resist stripper, followed by cleaning. Thus, as shown in Fig. 5, the gate lines 14gl, the gate electrodes 14gd, and the gate terminals 14gt are simultaneously formed.

### <Gate insulating film forming step>

A silicon nitride film (e.g., having a thickness of about 350 nm) and a silicon oxide film (e.g., having a thickness of about 50 nm) are formed in sequence by a plasma CVD method on the substrate provided with components such as the gate electrodes 14gd and the gate terminals 14gt. Thus, as shown in Fig. 6, the gate insulating film 16 is formed.

### <Second patterning step>

A first semiconductor film (e.g., having a thickness of about 40 nm) containing an In-Ga-Zn-O first oxide semiconductor is formed by a sputtering method on the substrate provided with the gate insulating film 16. In the first oxide semiconductor, indium preferably has a higher proportion than gallium and than zinc. Subsequently, a resist pattern is formed on the first semiconductor film by photolithography with a second photomask. Then, using this resist pattern as a mask, the first semiconductor film is patterned by wet etching with an oxalic acid solution. Thereafter, the resist pattern is stripped with a resist stripper, followed by cleaning. Thus, as shown in Fig. 7, the first oxide semiconductor layer 18sl1 is formed.

### <Third patterning step>

A second semiconductor film (e.g., having a thickness of about 60 nm) containing an In-Ga-Zn-O second oxide semiconductor is formed by a sputtering method on the substrate provided with the first oxide semiconductor layer 18sl1. In the second oxide semiconductor, gallium preferably has a higher proportion than indium and than zinc. Subsequently, a resist pattern is formed on the second semiconductor film by photolithography with a third photomask. Then, using this resist pattern as a mask, the second semiconductor film is patterned by wet etching with an oxalic acid solution. Thereafter, the resist pattern is stripped with a resist stripper, followed by cleaning. Thus, as shown in Fig. 8, the second oxide semiconductor layer 18sl2 is formed. As a result, the oxide semiconductor layer 18sl is formed.

### <Fourth patterning step>

A molybdenum film 24 (e.g., having a thickness of about 50 nm), an aluminum film 21 (e.g., having a thickness of about 300 nm), and a molybdenum film 22 (e.g., having a thickness of about 100 nm) are formed in sequence by a sputtering method on the substrate provided with the oxide semiconductor layer 18sl. Thus, a layered conductive film is formed. Subsequently, a resist pattern is formed on the layered conductive film by photolithography with a fourth photomask. The resist pattern is formed on the portions where the source lines 24sl, source electrodes 24sd, drain electrodes 24dd, and source terminals 24st are to be formed. Then, using this resist pattern as a mask, the layered conductive film is patterned by RIE using chlorine-containing gas. Thus, as shown in Fig. 9, the source lines 24sl, the source electrodes 24sd, the drain electrodes 24dd, and the source terminals 24st are simultaneously formed. At this time, the first oxide semiconductor layer 18sl1 is covered with the second oxide semiconductor layer 18sl2. This can decrease the reduction of the first oxide semiconductor layer 18sl1 by plasma of chlorine-containing gas (plasma treatment).

As for the conditions for the etching by RIE, the material gas used is a gas mixture of Cl₂ (flow rate: about 100 sccm) and BCl₃ (flow rate: about 100 sccm), the pressure in the chamber is about 4 Pa, and the highfrequency power is about 1100 W.

### <Fifth patterning step (protective insulating film forming step and annealing step)>

A silicon nitride film is formed by a plasma CVD method on the substrate provided with components such as the source electrodes 24sd and the drain electrodes 24dd. Thus, as shown in Fig. 10, the protective insulating film 28 (e.g., having a thickness of about 300 nm) is formed. At this time, the first oxide semiconductor layer 18sl1 is covered with the second oxide semiconductor layer 18sl2. This can decrease the reduction of the first oxide semiconductor layer 18sl1 by hydrogen plasma (plasma treatment) during the formation of the protective insulating film 28 by a plasma CVD method.

Then, the substrate provided with the protective insulating film 28 is subjected to a high-temperature annealing treatment at about 100°C to 450°C in an oxygen-containing atmosphere under atmospheric pressure. The treatment was performed in an annealing chamber using oxygen gas as a carrier gas. Even if the channel region 18c of the oxide semiconductor layer 18sl has been exposed to plasma and oxygen has been separated from the channel region 18c in the formation of the protective insulating film 28 by a plasma CVD method, this annealing treatment repairs the oxygen defect of the oxide semiconductor layer 18sl, thus stabilizing the characteristics of the semiconductor layer 18sl.

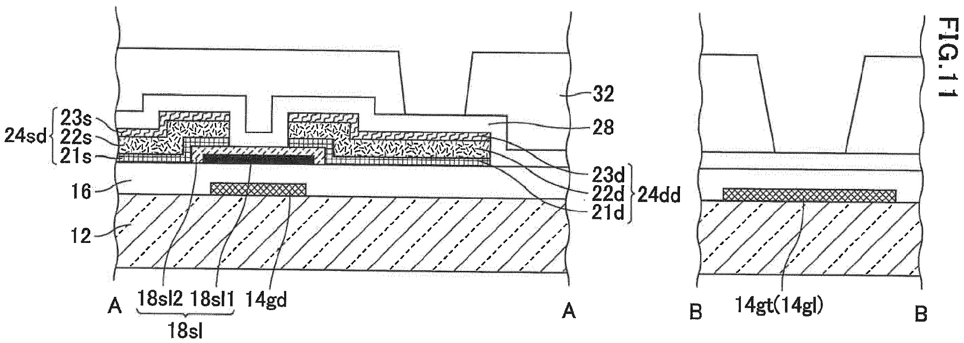

Subsequently, a transparent insulating resin film (e.g., having a thickness of about 2 µm) containing a positive photosensitive acrylic transparent resin is formed on the annealed substrate by a spin coating method or a slit coating method. Then (after pre-baking), the transparent insulating resin film is patterned by photolithography with a fifth photomask. Specifically, the patterning is performed by exposing the portions where the contact holes 20a, 29a, and 29c are to be formed and the portions to be removed, followed by development. The entire surface is then exposed at an exposure dose of 280 to 350 mJ/cm² to breach the resin, followed by post-baking at 200°C to 230°C. Thus, as shown in Fig. 11, the protective insulating film 32 is formed.

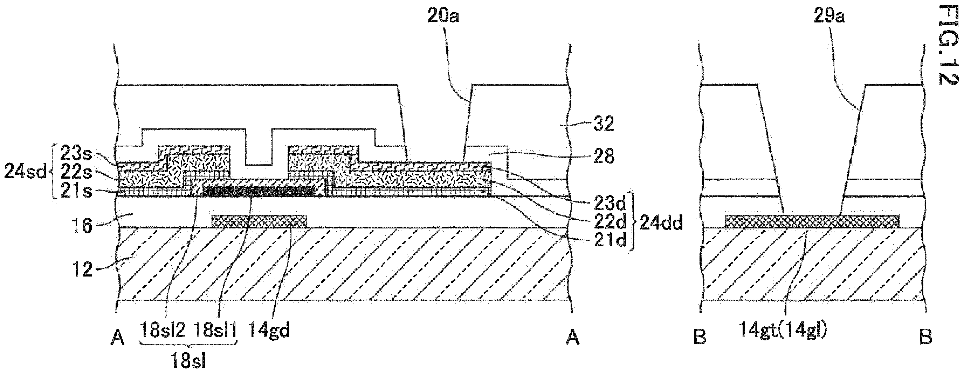

Subsequently, on the substrate provided with the protective insulating film 32 is formed a resist pattern by photolithography with the fifth photomask such that the resist pattern has openings on the portions where the contact holes 20a, 29a, and 29c are to be formed. Then, using this resist pattern as a mask, the gate insulating film 16 and the protective insulating film 28 are patterned by RIE using fluorine-containing gas. Thus, as shown in Fig. 12, the contact holes 20a, 29a, and 29c are formed.

### <Sixth patterning step>

A transparent conductive film (e.g., having a thickness of about 70 nm) such as an ITO or IZO film is formed by a sputtering method on the substrate with the protective insulating films 28 and 32 patterned. A resist pattern is then formed on the transparent conductive film by photolithography with a sixth photomask. The resist pattern is formed on the portions where the common electrode 30cd, the connection electrodes 34, the gate connection electrodes 30gt1, and the source connection electrodes 30st1 are to be formed. Then, using this resist pattern as a mask, the transparent conductive film is patterned by wet etching using an oxalic acid solution. The resist pattern is then stripped with a resist stripper, followed by cleaning. Thus, as shown in Fig. 13, the common electrode 30cd, the connection electrode 34, the gate connection electrode 30gt1, and the source connection electrode 30st1 are formed.

### <Seventh patterning step>

A silicon oxide film or silicon nitride film is formed by a plasma CVD method on the substrate provided with components such as the common electrode 30cd and the connection electrodes 34, whereby a protective insulating film 36 (e.g., having a thickness of about 300 nm) is formed.

Subsequently, on the substrate provided with the protective insulating film 36, a resist pattern is formed by photolithography with a seventh photomask such that the resist pattern has openings on the portions where the contact holes 20b, 29b, and 29d are to be formed. Then, using this resist pattern as a mask, the protective insulating film 36 is patterned by RIE using fluorine-containing gas. The resist pattern is then stripped with a resist stripper, followed by cleaning. Thus, as shown in Fig. 14, the contact holes 20b, 29b, and 29d are formed.

### <Eighth patterning step>

A transparent conductive film (e.g., having a thickness of about 70 nm) such as an ITO or IZO film is formed by a sputtering method on the substrate provided with the contact holes 20b, 29b, and 29d. Then, a resist pattern is formed on the transparent conductive film by photolithography with an eighth photomask. The resist pattern is formed on the portions where the pixel electrodes 30pd, the gate connection electrodes 30gt2, and the source connection electrodes 30st2 are to be formed. Then, using this resist pattern as a mask, the transparent conductive film is patterned by wet etching using an oxalic acid solution. The resist pattern is then stripped with a resist stripper, followed by cleaning. Thus, the pixel electrodes 30pd, the gate connection electrodes 30gt2, and the source connection electrodes 30st2 are formed.

Through the above steps, the TFT substrate 10 shown in Fig. 4 can be produced.

### <Counter substrate production step>

First, for example, a black-colored photosensitive resin is applied to an insulating substrate such as a glass substrate by a spin coating method or a slit coating method. The coating film is then patterned by exposure using a photomask and development. Thus, a black matrix is formed.

Subsequently, a negative photosensitive acrylic transparent resin colored red, green, or blue, for example, is applied to the substrate provided with the black matrix. The obtained coating film is patterned by exposure via a photomask and development. Thus, a colored layer of a selected color (e.g., red layer) is formed. The same treatment is repeated to form colored layers of the other two colors (e.g., green layer and blue layer). Thus, color filters are formed.

Next, a transparent insulating resin film containing, for example, an acrylic transparent resin is formed by a spin coating method or a slit coating method on the substrate provided with the color filters. Thus, an overcoat layer is formed.

Then, a positive phenol novolac photosensitive resin is applied by a spin coating method to the substrate provided with the overcoat layer. The obtained coating film is patterned by exposure via a photomask and development. Thus, photo spacers are formed.

Through the above step, the counter substrate 50 can be produced.

### <Attaching step>

First, a polyimide resin is applied to a surface of the TFT substrate 10 by a printing method. The coating film is then fired and subjected to rubbing treatment to form an alignment film 55. The polyimide resin is also applied to a surface of the counter substrate 50 by a printing method. The coating film is then fired and subjected to rubbing treatment to form an alignment film 56.

Next, a seal 51 made of, for example, a resin having both ultraviolet-curability and heat-curability is drawn in a rectangular frame shape with a dispenser or the like on the counter substrate 50 provided with the alignment film 56. Subsequently, a predetermined amount of a liquid crystal material is dropped onto the region inside the seal 51 on the counter substrate 50.

The counter substrate 50 with the liquid crystal material dropped and the TFT substrate 10 provided with the alignment film 55 are attached to each other under reduced pressure. The resulting assembly is exposed to atmospheric pressure to pressurize the surfaces of the assembly. The seal 51 of the assembly is irradiated with ultraviolet (UV) light to be pre-cured. The assembly is then heated to cure the seal 51 to bond the TFT substrate 10 and the counter substrate 50 to each other.

Then, polarizing plates 57 and 58 are attached to the outer surfaces of the TFT substrate 10 and the counter substrate 50 bonded to each other.

### <Mounting step>

ACFs are formed on the terminal region 10a of the assembly with the polarizing plates 57 and 58 on the respective surfaces. The gate driver IC chips 53 and the source driver IC chips 54 are bonded by thermal compression to the terminal region 10a via the ACFs, whereby the driver IC chips 53 and 54 are mounted on the assembly.

Through the above steps, the liquid crystal display device S can be produced.

According to the present embodiment, the oxide semiconductor layer 18sl includes the first oxide semiconductor layer 18sl1 and the second oxide semiconductor layer 18sl2 covering the first oxide semiconductor layer 18sl1. Thus, each TFT 26 can achieve high mobility owing to the first oxide semiconductor layer 18sl1 (lower layer) and a stable threshold value owing to the second oxide semiconductor layer 18sl2 (upper layer). Moreover, it is possible to prevent the threshold value of each TFT 26 from shifting to the negative side or prevent the oxide semiconductor layer 18sl from becoming conductive in the steps (plasma treatment) after the patterning of the oxide semiconductor layer 18sl. As a result, each TFT 26 can have stable TFT characteristics.

### <<Embodiment 2>>

The present embodiment mainly describes the characteristic features of the present embodiment, and omits the descriptions of the same features as those of Embodiment 1. In the present embodiment and Embodiment 1, members that exhibit the same or similar functions are donated by the same reference signs and the description of the members are omitted in the present embodiment. The present embodiment is substantially the same as Embodiment 1 except that the TFTs are etch stopper-type TFTs as described below.

### <Structure of TFT substrate 10>

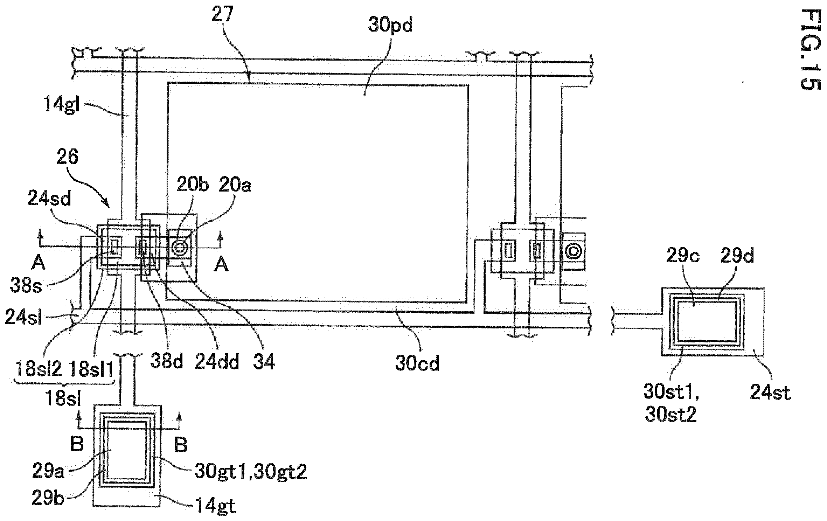

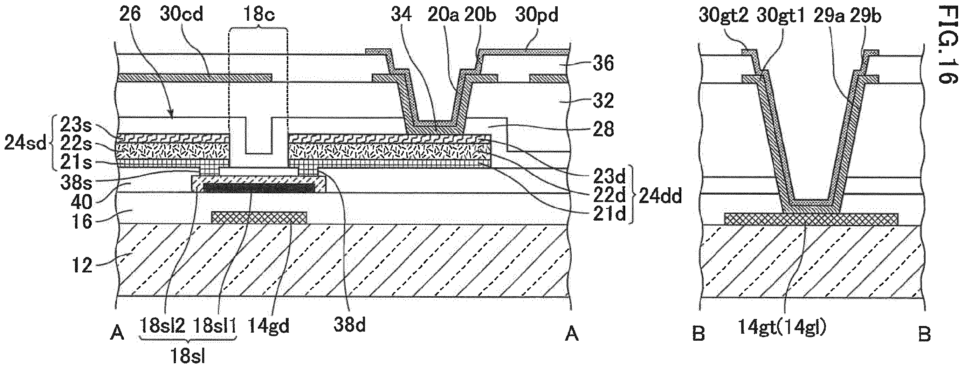

Fig. 15 and Fig. 16 are schematic views illustrating the TFT substrate 10 according to the present embodiment. Fig. 15 is a schematic plan view illustrating one pixel and the terminal of each line. Fig. 16 includes cross-sectional views illustrating, from left to right in the figure, cross-sectional structures along the A-A line and the B-B line in Fig. 15.

In the present embodiment, as shown in Fig. 15, the TFT substrate 10 has the same plan layout as the TFT substrate 10 according to Embodiment 1 except that the later-described etching stopper layer has contact holes 38s and 38d overlapping the source electrode 24sd and the drain electrode 24dd.

As shown in Fig. 16, the TFT substrate 10 includes an etching stopper layer 40 containing silicon oxide (SiO₂). The etching stopper layer 40 covers the oxide semiconductor layer 18sl and the gate insulating film 16 except for the portions where the contact holes 38s and 38d are formed.

The source electrode 24sd and the drain electrode 24dd are formed on the etching stopper layer 40 and connected to the oxide semiconductor layer 18sl through the contact holes 38s and 38d formed in the etching stopper layer 40.

A contact hole 29a for connection of the gate connection electrode 30gt1 is formed in the gate insulating film 16, the etching stopper layer 40, and the protective insulating film 28.

### -Production method-

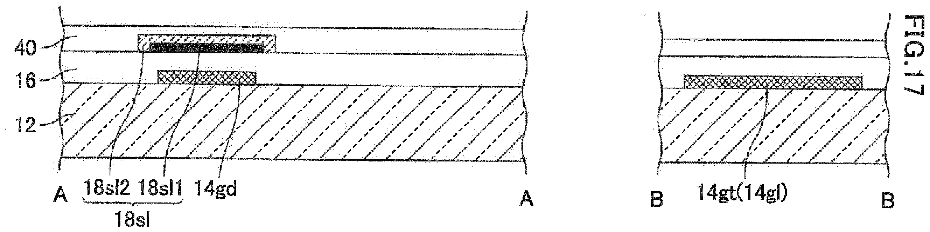

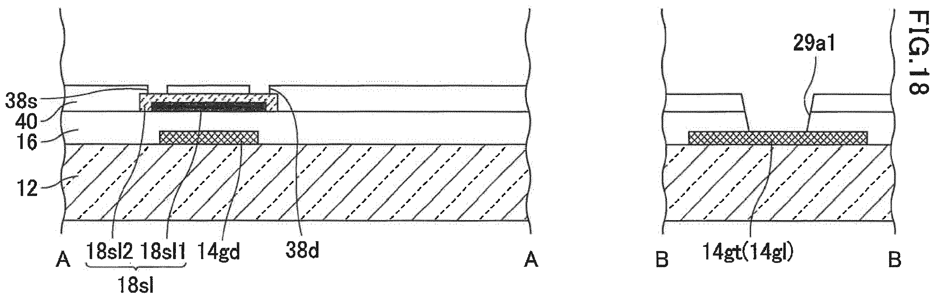

Next, with reference to Fig. 17 and Fig. 18, an exemplary method for producing the TFT substrate 10 according to the present embodiment is described. Fig. 17 and Fig. 18 each includes cross-sectional views of portions corresponding to the portions illustrated in Fig. 16, each illustrating a fourth patterning step in the method for producing the TFT substrate 10.

### <TFT substrate producing step>

The TFT substrate producing step includes a first to ninth patterning steps.

### <First to third patterning steps>

First, a first to third patterning steps are performed as in Embodiment 1.

### <Fourth patterning step>

A silicon oxide film is formed by a plasma CVD method on the substrate provided with the oxide semiconductor layer 18sl. Thus, as shown in Fig. 17, the etching stopper layer 40 (e.g., having a thickness of about 200 nm) is formed. At this time, the first oxide semiconductor layer 18sl1 is covered with the second oxide semiconductor layer 18sl2. This can moderate the reduction of the first oxide semiconductor layer 18sl1 by hydrogen plasma (plasma treatment) during the formation of the etching stopper layer 40 by a plasma CVD method.

Subsequently, on the substrate provided with the etching stopper layer 40 is formed a resist pattern by photolithography with a fourth photomask such that the resist pattern has openings on the portions where the contact holes 29a, 38s, and 38d are to be formed. Then, using this resist pattern as a mask, the gate insulating film 16 and the etching stopper layer 40 are patterned by RIE using fluorine-containing gas. Thus, as shown in Fig. 18, the contact holes 38s and 38d and openings 29a1 constituting the contact holes 29a are formed.

### <Fifth patterning step>

Subsequently, the same step as the fourth patterning step of Embodiment 1 is performed. The etching stopper layer 40 functions as a channel protective film for the oxide semiconductor layer 18sl. The etching stopper layer thus can protect the channel region 18c of the oxide semiconductor layer 18sl from plasma damage during the patterning of the layered conductive film by RIE. In addition, at this time, the first oxide semiconductor layer 18sl1 is covered with the second oxide semiconductor layer 18sl2 and the oxide semiconductor layer 18sl is covered with the etching stopper layer 40. This can moderate the reduction of the first oxide semiconductor layer 18sl1 by plasma of chlorine-containing gas (plasma treatment).

### <Sixth patterning step (protective insulating film formation step and annealing step)>

Subsequently, the same step as the fifth patterning step (protective insulating film forming step and annealing step) of Embodiment 1 is performed. At this time, the first oxide semiconductor layer 18sl1 is covered with the second oxide semiconductor layer 18sl2 and the oxide semiconductor layer 18sl is covered with the etching stopper layer 40. This can moderate the reduction of the first oxide semiconductor layer 18sl1 by hydrogen plasma (plasma treatment) during the formation of the protective insulating film 28 by a plasma CVD method. The etching stopper layer 40 containing silicon oxide usually has a higher oxygen transmittance than a silicon nitride film. The annealing treatment in this step thus effectively supplies oxygen of the annealing treatment to the channel region 18c of the oxide semiconductor layer 18sl. This repairs oxygen deficiency-derived lattice defects potentially present in the oxide semiconductor layer 18sl, further stabilizing the characteristics of the semiconductor layer 18sl.

### <Seventh to ninth patterning steps>

Then, the same steps as the sixth to eighth patterning steps of Embodiment 1 are performed. Thus, the TFT substrate 10 shown in Fig. 16 is produced.

According to the present embodiment, the oxide semiconductor layer 18sl includes the first oxide semiconductor layer 18sl1 and the second oxide semiconductor layer 18sl2 covering the first oxide semiconductor layer 18sl1. Thus, as in Embodiment 1, each TFT 26 can achieve high mobility owing to the first oxide semiconductor layer 18sl1 (lower layer) and a stable threshold value owing to the second oxide semiconductor layer 18sl2 (upper layer). Moreover, it is possible to prevent the threshold value of each TFT 26 from shifting to the negative side or prevent the oxide semiconductor layer 18sl from becoming conductive in the steps (plasma treatment) after the patterning of the oxide semiconductor layer 18sl. As a result, each TFT 26 can have stable TFT characteristics.

### <<Embodiment 3>>

The present embodiment mainly describes the characteristic features of the present embodiment, and omits the descriptions of the same features as those of Embodiments 1 and 2. In the present embodiment and Embodiments 1 and 2, members that exhibit the same or similar functions are donated by the same reference signs and the description of the members are omitted in the present embodiment. The present embodiment is substantially the same as Embodiment 1 except that the oxide semiconductor layer is arranged inside the gate electrode.

### <Structure of TFT substrate 10>

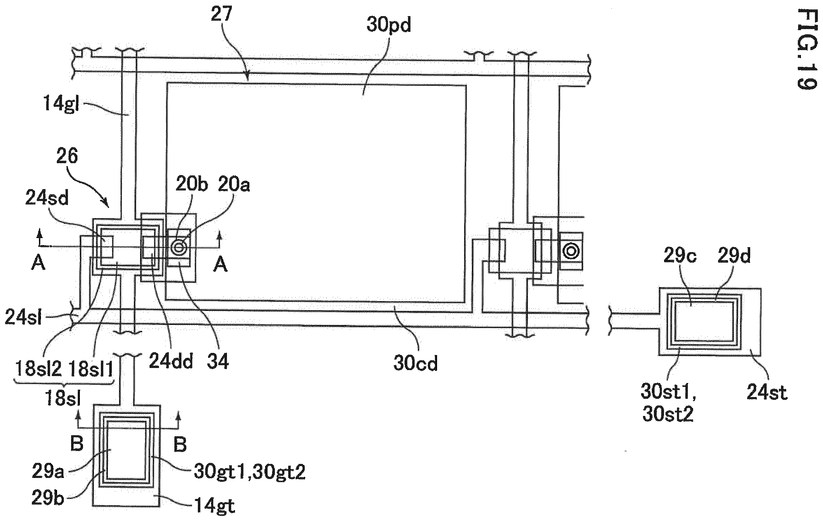

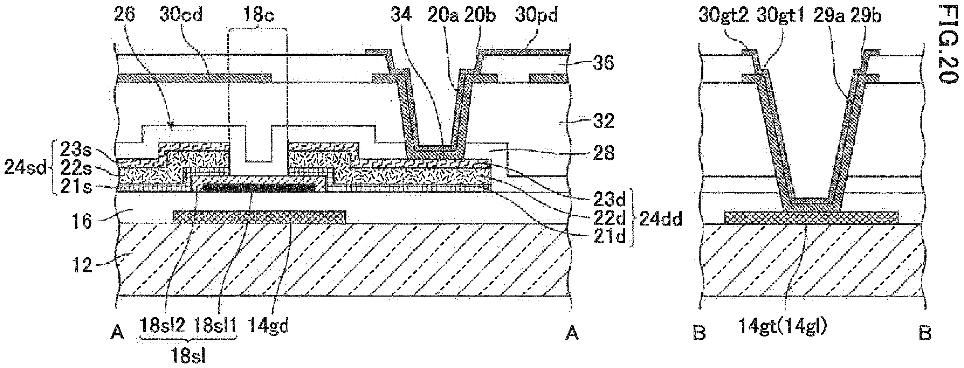

Fig. 19 and Fig. 20 are schematic views illustrating the TFT substrate 10 according to the present embodiment. Fig. 19 is a schematic plan view illustrating one pixel and the terminal of each line. Fig. 20 includes cross-sectional views illustrating, from left to right in the figure, cross-sectional structures along the A-A line and the B-B line in Fig. 19.

In the present embodiment, as shown in Fig. 19, the TFT substrate 10 has the same plan layout as the TFT substrate 10 according to Embodiment 1 except that the gate electrode 14gd is larger than the oxide semiconductor layer 18sl and overlaps the entire oxide semiconductor layer 18sl.

In the TFT substrate 10, as shown in Fig. 20, in the channel length direction of the TFT 26, the width of the gate electrode 14gd is larger than the width of the oxide semiconductor layer 18sl.

### -Production method-

The TFT substrate 10 according to the present embodiment can be produced by the same steps as those for the TFT substrate 10 according to Embodiment 1.

### <<Embodiment 4>>

The present embodiment mainly describes the characteristic features of the present embodiment, and omits the descriptions of the same features as those of Embodiments 1 and 2. In the present embodiment and Embodiments 1 and 2, members that exhibit the same or similar functions are donated by the same reference signs and the description of the members are omitted in the present embodiment. The present embodiment is substantially the same as Embodiment 2 except that the oxide semiconductor layer is arranged inside the gate electrode.

### <Structure of TFT substrate 10>

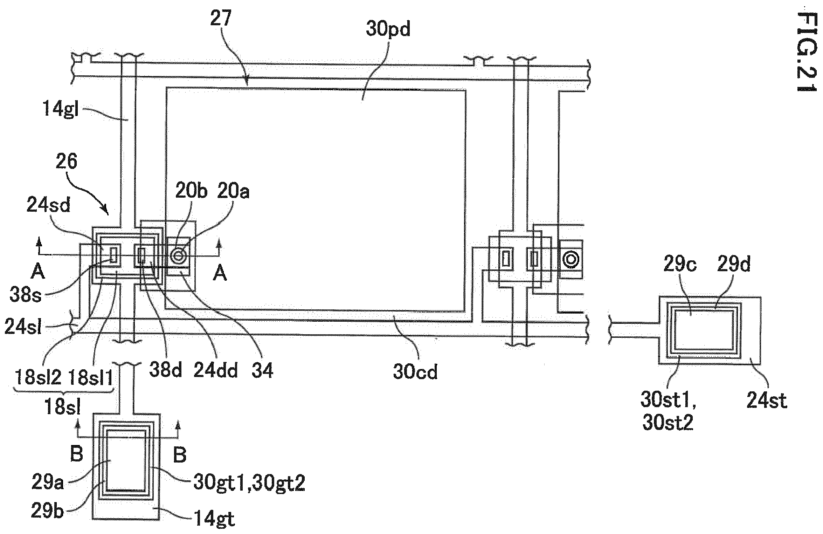

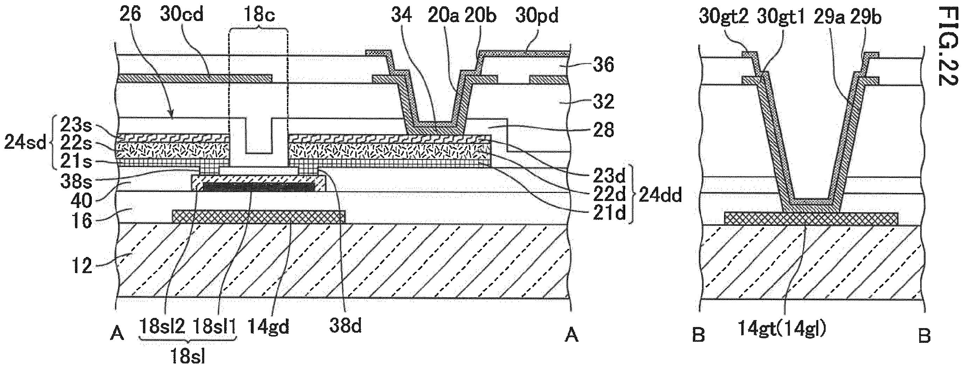

Fig. 21 and Fig. 22 are schematic views illustrating the TFT substrate 10 according to the present embodiment. Fig. 21 is a schematic plan view illustrating one pixel and the terminal of each line. Fig. 22 includes cross-sectional views illustrating, from left to right in the figure, cross-sectional structures along the A-A line and the B-B line in Fig. 21.

In the present embodiment, as shown in Fig. 21, the TFT substrate 10 has the same plan layout as the TFT substrate 10 according to Embodiment 2 except that the gate electrode 14gd is larger than the oxide semiconductor layer 18sl and overlaps the entire oxide semiconductor layer 18sl.

In the TFT substrate 10, as shown in Fig. 22, in the channel length direction of the TFT 26, the width of the gate electrode 14gd is larger than the width of the oxide semiconductor layer 18sl.

### -Production method-

The TFT substrate 10 according to the present embodiment can be produced by the same steps as those for the TFT substrate 10 according to Embodiment 2.

The above embodiments illustrate an exemplary case where the source electrode 24sd and the drain electrode 24dd each has a layered structure (Mo/Al/Mo) including the molybdenum layer 21s or 21d as the first conductive layer, the aluminum layer 22s or 22d as the second conductive layer, and the molybdenum layer 23s or 23d as the third conductive layer. The present invention, however, should not be limited thereto.

Specifically, the first conductive layers 21s and 21d may contain, instead of molybdenum (Mo), molybdenum nitride (MoN) or an alloy containing molybdenum as a main component. Alternatively, the first conductive layers 21s and 21d may contain a refractory metal such as chromium (Cr), niobium (Nb), tantalum (Ta), tungsten (W), an alloy containing any of these metals as a main component, or a nitride or oxide of any of these metals or the alloy. The first conductive layers 21s and 21d may contain a group V or group VI metal element, an alloy containing the metal element as a main component, or a nitride or oxide of the metal element or the alloy. The first conductive layers 21s and 21d may contain, instead of molybdenum (Mo), a refractory metal such as titanium (Ti), titanium nitride (TiN), titanium oxide (TiO), or an alloy containing titanium (Ti) as a main component, or may contain a group IV metal element, an alloy containing the metal element as a main component, or a nitride or oxide of the metal element or the alloy.

The second conductive layers 22s and 22d may contain copper (Cu) or silver (Ag) instead of aluminum (Al), or may contain any other low-resistance metal material having a resistivity of 5 µΩ·cm or lower.

The third conductive layers 23s and 23d may contain, instead of molybdenum (Mo), molybdenum nitride (MoN) or an alloy containing molybdenum as a main component. Alternatively, the third conductive layers 23s and 23d may contain a refractory metal such as chromium (Cr), niobium (Nb), tantalum (Ta), tungsten (W), an alloy containing any of these metals as a main component, or a nitride or oxide of any of these metals or the alloy. The third conductive layer 23s and 23d may contain a group V or group VI metal element, an alloy containing the metal element as a main component, or a nitride or oxide of the metal element or the alloy. The third conductive layers 23s and 23d may contain, instead of molybdenum (Mo), a refractory metal such as titanium (Ti), titanium nitride (TiN), titanium oxide (TiO), or an alloy containing titanium (Ti) as a main component, or may contain a group IV metal element, an alloy containing the metal element as a main component, or a nitride or oxide of the metal element or the alloy.

The above embodiments illustrate a TFT formed using an In-Ga-Zn-O oxide semiconductor layer. The present invention, however, can also be applied to TFT substrates with TFTs formed using a different oxide semiconductor layer of, for example, indium silicon zinc oxide (In-Si-Zn-O), indium aluminum zinc oxide (In-Al-Zn-O), tin silicon zinc oxide (Sn-Si-Zn-O), tin aluminum zinc oxide (Sn-Al-Zn-O), tin gallium zinc oxide (Sn-Ga-Zn-O), gallium silicon zinc oxide (Ga-Si-Zn-O), gallium aluminum zinc oxide (Ga-Al-Zn-O), indium copper zinc oxide (In-Cu-Zn-O), tin copper zinc oxide (Sn-Cu-Zn-O), indium tin gallium oxide (In-Sn-Ga-O), indium tin zinc oxide (In-Sn-Zn-O), indium tin gallium zinc oxide (In-Sn-Ga-Zn-O), tin oxide (Zn-O), or indium oxide (In-O). The present invention can also be applied to TFT substrates including TFTs combining any of these different oxide semiconductor layers.

The above embodiments show examples in which each of the first oxide semiconductor layer 18sl1 and the second oxide semiconductor layer 18sl2 is a monolayer. Each of the oxide semiconductor layers 18sl1 and 18sl2, however, may include a plurality of oxide semiconductor layers.

The above embodiments perform, in the TFT substrate producing step, the annealing treatment after the formation of the protective insulating film 28 but before the formation of the contact holes in the protective insulating film 28. The annealing treatment, however, may be performed after the formation of the contact holes in the protective insulating film 28.

The above embodiments show examples in which the TFT substrate 10 constitutes the transmissive liquid crystal display device S. The present invention, however, should not be limited thereto, and the TFT substrate 10 according to the present invention can be applied to a reflective or transflective liquid crystal display device or other display devices such as organic electroluminescence (EL) display devices, as well as to methods for producing these devices.

### [Additional remarks]

A first aspect of the present invention may be a TFT substrate (10) including: a base substrate (12); and a TFT (26) including a gate electrode (14gd) disposed on the base substrate (12), a gate insulating film (16) covering the gate electrode (14gd), a semiconductor layer (18sl) disposed on the gate insulating film (16) and overlapping the gate electrode (14gd), and a source electrode (24sd) and a drain electrode (24dd) facing each other on the semiconductor layer (18sl), part of each of the source electrode (24sd) and the drain electrode (24dd) connected to the semiconductor layer (18sl), wherein the semiconductor layer (18sl) includes a first semiconductor layer containing a first oxide semiconductor (18sl1) and a second semiconductor layer containing a second oxide semiconductor (18sl2), with the second semiconductor layer (18sl2) covering the first semiconductor layer (18sl1).

According to the above structure, the semiconductor layer (18sl) includes the first semiconductor layer (18sl1) and the second semiconductor layer (18sl2) covering the first semiconductor layer (18sl1). Thus, each TFT (26) can achieve high mobility owing to the first semiconductor layer (18sl1) (lower layer) and a stable threshold value owing to the second semiconductor layer (18sl2) (upper layer). Moreover, it is possible to prevent the threshold value of each TFT (26) from shifting to the negative side or prevent the semiconductor layer (18sl) from becoming conductive in the steps (plasma treatment) after the patterning of the semiconductor layer (18sl). As a result, each TFT (26) can have stable TFT characteristics.

According to a second aspect of the present invention, each of the first oxide semiconductor and the second oxide semiconductor in the TFT substrate (10) of the first aspect of the present invention may contain indium, gallium, zinc, and oxygen. In the first oxide semiconductor, indium may have a higher proportion than gallium and than zinc, and in the second oxide semiconductor, gallium may have a higher proportion than indium and than zinc.

The above structure allows the effects of the present invention to be specifically exerted.

A third aspect of the present invention may be a liquid crystal display device (S) including: the TFT substrate (10) of the first or second aspect of the present invention; a counter substrate (50) facing the TFT substrate (10); and a liquid crystal layer (52) disposed between the TFT substrate (10) and the counter substrate (50).

The above structure allows the TFT substrate (10) of the first or second aspect to have stable TFT characteristics, thus improving the yield of the liquid crystal display device (S).

A fourth aspect of the present invention may be a method for producing the TFT substrate (10) including: a first patterning step of forming a conductive film on the base substrate (12) and patterning the conductive film with a first photomask to form the gate electrode (14gd), a gate insulating film forming step of forming the gate insulating film (16) to cover the gate electrode (14gd); a second patterning step of forming a first semiconductor film containing a first oxide semiconductor on the gate insulating film (16) and patterning the first semiconductor film with a second photomask to form the first semiconductor layer (18sl1); a third patterning step of forming a second semiconductor film containing a second oxide semiconductor to cover the first semiconductor layer (18sl1) and patterning the second semiconductor film with a third photomask to form the second semiconductor layer (18sl2) to cover the first semiconductor layer (18sl1); and a fourth patterning step of forming a conductive film to cover the first semiconductor layer (18sl1) and the second semiconductor layer (18sl2) and patterning the conductive film by dry etching with a fourth photomask to form the source electrode (24sd) and the drain electrode (24dd).

The above production method forms the second semiconductor layer (18sl2) to cover the first semiconductor layer (18sl1). Thus, each TFT (26) can achieve high mobility owing to the first semiconductor layer (18sl1) (lower layer) and a stable threshold value owing to the second semiconductor layer (18sl2) (upper layer). Moreover, it is possible to prevent the threshold value of each TFT (26) from shifting to the negative side or prevent the first semiconductor layer (18sl1) and the second semiconductor layer (18sl2) from becoming conductive in the steps (plasma treatment) after the patterning of the first semiconductor layer (18sl1) and the second semiconductor layer (18sl2). As a result, the TFT substrate (10) can be produced in which each TFT (26) can have stable TFT characteristics.

According to a fifth aspect of the present invention, in the method for producing the TFT substrate (10) according to the fourth aspect of the present invention, each of the first oxide semiconductor and the second oxide semiconductor may contain indium, gallium, zinc, and oxygen. In the first oxide semiconductor, indium may have a higher proportion than gallium and than zinc, and in the second oxide semiconductor, gallium may have a higher proportion than indium and than zinc.

The above production method allows the effects of the present invention to be specifically exerted.

The above aspects of the present invention may be appropriately combined within the spirit of the present invention.

### REFERENCE SIGNS LIST

10: TFT substrate (thin film transistor substrate)
12: insulating substrate (base substrate)
14gd: gate electrode
16: gate insulating film
18sl: oxide semiconductor layer (semiconductor layer)
18sl1: first oxide semiconductor layer (first semiconductor layer)
18sl2: second oxide semiconductor layer (second semiconductor layer)
20a, 20b, 29a, 29b, 38s, 38d: contact hole
24sd: source electrode
24dd: drain electrode
21s, 21d: molybdenum layer (first conductive layer)
22s, 22d: aluminum layer (second conductive layer)
23s, 23d: molybdenum layer (third conductive layer)
26: TFT (thin film transistor)
28, 32, 36: protective insulating film
30cd: common electrode (transparent conductive layer)
30pd: pixel electrode (transparent conductive layer)
34: connection electrode
40: etching stopper layer
50: counter substrate
52: liquid crystal layer
S: liquid crystal display device

## Claims

1. A thin film transistor substrate comprising:
a base substrate; and
a thin film transistor including
a gate electrode disposed on the base substrate,
a gate insulating film covering the gate electrode, a semiconductor layer disposed on the gate insulating film and overlapping the gate electrode, and
a source electrode and a drain electrode facing each other on the semiconductor layer, part of each of the source electrode and the drain electrode connected to the semiconductor layer,
wherein the semiconductor layer includes a first semiconductor layer containing a first oxide semiconductor and a second semiconductor layer containing a second oxide semiconductor, with the second semiconductor layer covering the first semiconductor layer.

2. The thin film transistor substrate according to claim 1,
wherein each of the first oxide semiconductor and the second oxide semiconductor contains indium, gallium, zinc, and oxygen;
in the first oxide semiconductor, indium .has a higher proportion than gallium and than zinc; and
in the second oxide semiconductor, gallium has a higher proportion than indium and than zinc.

3. A liquid crystal display device comprising:
the thin film transistor substrate according to claim 1 or 2;
a counter substrate facing the thin film transistor substrate; and
a liquid crystal layer disposed between the thin film transistor substrate and the counter substrate.

4. A method for producing a thin film transistor substrate comprising:
a first patterning step of forming a conductive film on a base substrate and patterning the conductive film with a first photomask to form a gate electrode;
a gate insulating film forming step of forming a gate insulating film to cover the gate electrode;
a second patterning step of forming a first semiconductor film containing a first oxide semiconductor on the gate insulating film and patterning the first semiconductor film with a second photomask to form a first semiconductor layer;
a third patterning step of forming a second semiconductor film containing a second oxide semiconductor to cover the first semiconductor layer and patterning the second semiconductor film with a third photomask to form a second semiconductor layer to cover the first semiconductor layer; and
a fourth patterning step of forming a conductive film to cover the first semiconductor layer and the second semiconductor layer and patterning the conductive film by dry etching with a fourth photomask to form a source electrode and a drain electrode.

5. The method for producing a thin film transistor substrate according to claim 4,
wherein each of the first oxide semiconductor and the second oxide semiconductor contains indium, gallium, zinc, and oxygen;
in the first oxide semiconductor, indium has a higher proportion than gallium and than zinc; and
in the second oxide semiconductor, gallium has a higher proportion than indium and than zinc.
